# EUROPÄISCHE PATENTANMELDUNG

(11) **EP 1 594 162 A1**
(43) Veröffentlichungstag der Anmeldung: **09.11.2005**
(21) Anmeldenummer: 04010489.5
(22) Anmeldetag: 03.05.2004
(51) Int. Cl.: H01L 23/552, H01L 31/0203

(54) **Optoelektronischer Empfänger**

(71) Anmelder: Vishay Semiconductor GmbH, 74072 Heilbronn (DE)
(72) Erfinder: Giebler, Siegfried, 71543 Wüstenrot (DE)
(74) Vertreter: Manitz, Finsterwald & Partner GbR

(57) **Zusammenfassung**

Ein insbesondere als Fernsteuer-Empfangsmodul ausgebildeter optoelektronischer Empfänger besitzt ein lichtempfindliches Halbleiterbauelement (11) und einen Steuerschaltkreis (13). Das lichtempfindliche Halbleiterbauelement (11) ist mit dem Steuerschaltkreis (13) zur Übertragung von Empfangssignalen mittels einer Signalleitung (21) verbunden. Der optoelektronische Empfänger weist wenigstens einen Abschirm-Bonddraht (27) auf, der quer zu der Signalleitung (21) verläuft, die Signalleitung (21) übergreift und an beiden Enden mit einem Konstantpotentialanschluss (15) verbunden ist.

## Beschreibung

Die Erfindung betrifft einen optoelektronischen Empfänger, insbesondere ein Fernsteuer-Empfangsmodul, mit einem lichtempfindlichen Halbleiterbauelement und einem Steuerschaltkreis, wobei zur Übertragung von Empfangssignalen das lichtempfindliche Halbleiterbauelement mit dem Steuerschaltkreis mittels einer Signalleitung verbunden ist.

Ein derartiger optoelektronischer Empfänger wird beispielsweise im Zusammenhang mit Infrarot-Fernsteuerungen eingesetzt, um optische Signale, die von einem zugeordneten Sender ausgestrahlt werden, innerhalb des lichtempfindlichen Halbleiterbauelements in photoelektrische Empfangssignale umzuwandeln. Diese Empfangssignale werden mittels der Signalleitung an den Steuerschaltkreis weitergeleitet. Dort kann beispielsweise eine Filterung, Formung, Verstärkung oder Dekodierung der Empfangssignale oder eine sonstige Steuerung des lichtempfindlichen Halbleiterbauelements erfolgen.

Da derartige Fernsteuerungen über große Distanzen funktionsfähig sein sollen und damit sehr empfindlich gegenüber der optischen Strahlung sein müssen, besteht die Gefahr, dass elektromagnetische Störungen in die Empfangssignale eingekoppelt werden und diese verfälschen. Derartige elektromagnetische Störungen können beispielsweise durch Schaltnetzteile erzeugt werden, die in der Nähe des Empfängers angeordnet sind.

Um derartige Störungen zu unterdrücken, ist es beispielsweise bekannt, den Empfänger oder zumindest das lichtempfindliche Halbleiterbauelement mit zusätzlichen Gehäuseteilen aus Metall zu versehen, die auf ein konstantes elektrisches Potential gelegt werden. Trotz dieser Maßnahme kann die unerwünschte Beeinflussung durch elektromagnetische Störsignale nicht immer in dem erwünschten Maß beseitigt werden.

Es ist eine Aufgabe der Erfindung, einen optoelektronischen Empfänger mit einem lichtempfindlichen Halbleiterbauelement und einem Steuerschaltkreis noch besser gegen elektromagnetische Störungen zu schützen.

Diese Aufgabe wird durch eine optoelektronischen Empfänger mit den Merkmalen des Anspruchs 1 gelöst, und insbesondere dadurch, dass der Empfänger wenigstens einen Abschirm-Bonddraht aufweist, der quer zu der Signalleitung verläuft, die Signalleitung übergreift und an beiden Enden mit einem Konstantpotentialanschluss verbunden ist.

Der erfindungsgemäße Empfänger zeichnet sich also dadurch aus, dass ein oder mehrere Abschirm-Bonddrähte die Signalleitung überqueren, die zwischen dem lichtempfindlichen Halbleiterbauelement und dem Steuerschaltkreis verläuft. Der oder die Abschirm-Bonddrähte verlaufen dabei quer, d.h. senkrecht oder schräg zu der Signalleitung, und sie sind auf ein konstantes elektrisches Potential gelegt. Hierdurch ist also eine Art Umhüllung der Signalleitung verwirklicht. Somit ist eine Abschirmung der mittels der Signalleitung geführten, üblicherweise noch unverstärkten Empfangssignale gegenüber äußeren elektromagnetischen Störungen gewährleistet.

Ein besonderer Vorteil besteht darin, dass die mit dem oder den Abschirm-Bonddrähten verwirklichte zusätzliche Abschirmmaßnahme fertigungstechnisch auf einfache und somit kostengünstige Weise realisiert werden kann. Üblicherweise ist nämlich bei einem optoelektronischen Empfänger ohnehin die Anbringung von Bonddrähten vorgesehen, beispielsweise um eine Bondverbindung zwischen dem lichtempfindlichen Halbleiterelement und dem Steuerschaltkreis oder um Bondverbindungen zwischen diesen Bauelementen und Anschlussbeinchen des Empfängers herzustellen. Somit können die ohnehin genutzten Fertigungsanlagen ohne bedeutenden zusätzlichen Aufwand dazu genutzt werden, den oder die Abschirm-Bonddrähte anzubringen, um die zusätzliche Abschirmung der Signalleitung zu verwirklichen.

Die Erfindung ist natürlich nicht darauf beschränkt, dass über die Signalleitung ausschließlich Empfangssignale übertragen werden. Die erläuterten Vorteile der Erfindung werden vielmehr auch dann verwirklicht, wenn über die Signalleitung zusätzlich beispielsweise auch die Betriebsspannung für das lichtempfindliche Halbleiterelement übertragen wird.

Selbstverständlich kann die Erfindung unabhängig davon realisiert werden, ob das lichtempfindliche Halbleiterbauelement im sichtbaren, im infraroten oder im ultravioletten Spektralbereich detektiert. Das lichtempfindliche Halbleiterbauelement kann beispielsweise durch eine Photodiode oder einen Phototransistor gebildet sein.

Es ist bevorzugt, wenn der Abschirm-Bonddraht gemeinsam mit dem Konstantpotentialanschluss eine geschlossene Schleife bildet, d.h. wenn der Konstantpotentialanschluss die beiden Enden des Abschirm-Bonddrahts direkt miteinander verbindet. Hierdurch ist gewährleistet, dass die durch den Abschirm-Bonddraht und den Konstantpotentialanschluss gebildete geschlossene Schleife die Signalleitung umfänglich umschließt. Hierdurch wird eine besonders gute Abschirmwirkung erzielt.

Weiterhin ist es bevorzugt, wenn der Abschirm-Bonddraht an beiden Enden mit einem Masse-Leiterstreifen verbunden ist, d.h. einem Leiterstreifen, der ohnehin zum Aufbau des optoelektronischen Empfängers dient und der im Betrieb des Empfängers als Massekontakt vorgesehen ist. Der Leiterstreifen kann beispielsweise als ein als Stanz-/Biegeteil vorgesehener Metallstreifen oder als ein Platinenabschnitt ausgebildet sein.

Weitere Ausführungsformen der Erfindung sind in den Unteransprüchen genannt.

Die Erfindung wird nachfolgend lediglich beispielhaft unter Bezugnahme auf die Zeichnungen erläutert.
- Fig. 1: zeigt eine Seitenansicht einer ersten Ausführungsform eines optoelektronischen Empfängers.
- Fig. 2: zeigt eine Draufsicht der Ausführungsform gemäß Fig. 1.
- Fig. 3: zeigt eine Vorderansicht des Gehäuses der Ausführungsform gemäß Fig. 1.
- Fig. 4: zeigt eine Detailansicht der Verbindung von Photodiode und Steuerschaltkreis gemäß Fig. 2.
- Fig. 5: zeigt eine Seitenansicht einer weiteren Ausführungsform.

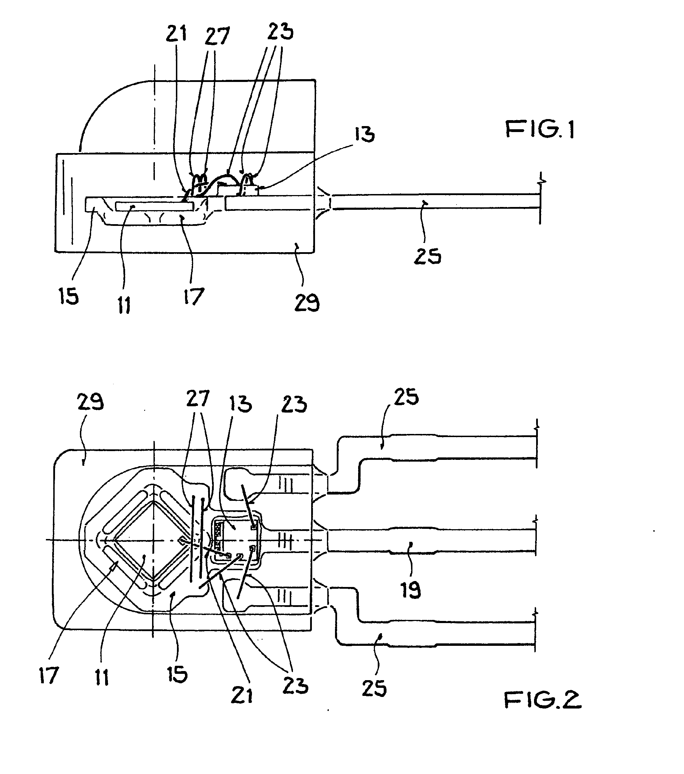

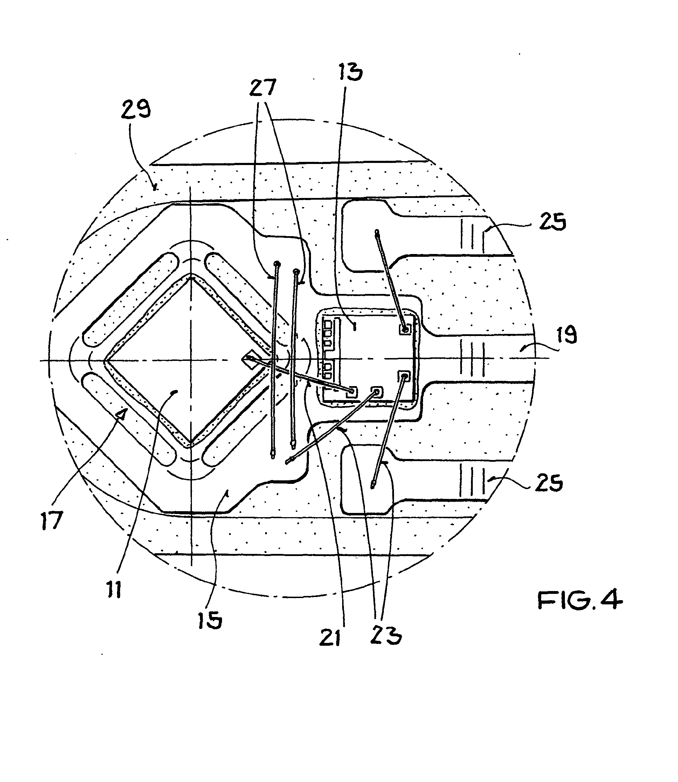

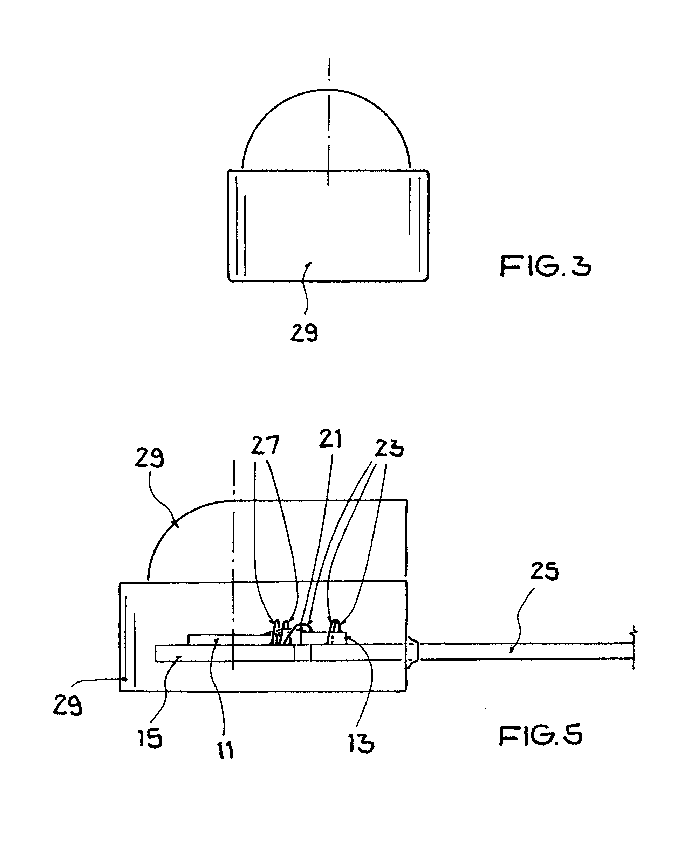

Der in den Fig. 1 bis 4 gezeigte optoelektronische Empfänger besitzt eine als lichtempfindliches Halbleiterbauelement dienende Silizium-Photodiode 11 sowie einen Steuerschaltkreis 13, die auf einem Masse-Leiterstreifen 15 aus Metall angeordnet, beispielsweise aufgeklebt sind. Im Bereich der Photodiode 11 besitzt der Masse-Leiterstreifen 15 eine wannenförmige Vertiefung 17, in die die Photodiode 11 eingesetzt ist. An dem der Vertiefung 17 gegenüber liegenden Ende ist der Masse-Leiterstreifen 15 als ein Masse-Anschlussbeinchen 19 ausgebildet.

Die Photodiode 11 und der Steuerschaltkreis 13 sind mittels eines Signal-Bonddrahts 21 miteinander verbunden, wobei die Photodiode 11 und der Steuerschaltkreis 13 dergestalt konfiguriert sind, dass der Signal-Bonddraht 21 zur Übertragung der Empfangssignale der Photodiode 11 an den Steuerschaltkreis 13 dient.

Weitere Bonddrähte 23 verbinden den Steuerschaltkreis 13 mit dem Masse-Leiterstreifen 15 und jeweils mit zwei äußeren Anschlussbeinchen 25. Eines dieser Anschlussbeinchen 25 kann beispielsweise zur Versorgung des Empfängers mit der Betriebsspannung dienen, während das andere Anschlussbeinchen 25 als Signalausgang dient.

Ferner sind zwei Abschirm-Bonddrähte 27 vorgesehen, die jeweils an beiden Enden mit dem Masse-Leiterstreifen 15 verbunden sind und die den Signal-Bonddraht 21 überqueren. Die beiden Abschirm-Bonddrähte 27 verlaufen in der Draufsicht gemäß Fig. 2 und 4 schräg zu dem Signal-Bonddraht 21 und parallel zueinander.

Die genannten Bauteile sind in einem gemeinsamen Gehäuse 29 vergossen, wobei die Anschlussbeinchen 19, 25 aus dem Gehäuse herausragen und letztlich parallel zueinander verlaufen. Das Gehäuse 29 ist im infraroten Spektralbereich, für den auch die Photodiode 11 empfindlich ist, transparent.

Der in den Fig. 1 bis 4 gezeigte optoelektronische Empfänger dient als Signalempfänger einer Infrarot-Fernsteuerung. Hierfür wandelt die Photodiode 11 die im Infraroten empfangenen optischen Signale in elektrische Signale um, die über den Signal-Bonddraht 21 zunächst an den Steuerschaltkreis 13 weitergeleitet werden. Dort erfolgt eine erste Signalverarbeitung, insbesondere eine Signalfilterung und -verstärkung. Anschließend werden die derartig vorverarbeiteten Empfangssignale über ein Anschlussbeinchen 25 des Empfängers ausgegeben.

Die Abschirm-Bonddrähte 27 bewirken eine vorteilhafte Abschirmung des Signal-Bonddrahts 21 gegenüber elektromagnetischen Störsignalen, da die Abschirm-Bonddrähte 27 gemeinsam mit dem Masse-Leiterstreifen 15 eine geschlossene Umhüllung des Signal-Bonddrahts 21 bilden. Der Masse-Leiterstreifen 15 ist im Betrieb des optoelektronischen Empfängers auf das elektrische Massepotential des Empfängers gesetzt. Aufgrund des Übergreifens des Signal-Bonddrahts 21 durch die somit ebenfalls auf das Massepotential gesetzten Abschirmbonddrähte 27 werden externe elektromagnetische Störsignale abgeschirmt, die sich anderenfalls ungeschwächt dem entlang des Signal-Bonddrahts 21 geführten Nutzsignal überlagern würden.

Diese vorteilhafte Abschirmungsmaßnahme kann fertigungstechnisch auf sehr einfache Weise verwirklicht werden, da bei der Herstellung des gezeigten Empfängers ohnehin Bonddrähte 21, 23 angebracht werden müssen. Das zusätzliche Anbringen der Abschirm-Bonddrähte 27 bedeutet demgegenüber keinen erheblichen Mehraufwand.

Eine weitere Maßnahme zur Abschirmung der Photodiode 11 gegen externe elektromagnetische Störsignale besteht in der Anordnung der Photodiode 11 in der wannenartigen Vertiefung 17 des Masse-Leiterstreifens 15. Der Boden und die Seitenwände der wannenförmigen Vertiefung 17 unterdrücken die von unten und von der Seite einfallende Störstrahlung oder schwächen diese zumindest ab. Ein weiterer Vorteil der Anordnung der Photodiode 11 in der wannenförmigen Vertiefung 17 besteht darin, dass der Signal-Bonddraht 21 einen flachen Verlauf von der Photodiode 11 zu dem Steuerschaltkreis 13 einnehmen kann, so dass das Übergreifen des Signal-Bonddrahts 21 mittels der Abschirm-Bonddrähte 27 auf besonders einfache Weise verwirklicht werden kann.

Gemäß einer vorteilhaften Weiterbildung ist die Photodiode 11 an der in Fig. 2 gezeigten Lichteintrittsseite mit einer Abschirmschicht aus einem leitfähigen und lichtdurchlässigen Material versehen, die beispielsweise mittels eines weiteren Bonddrahts oder durch ein entsprechendes Dotierungsprofil ebenfalls auf das Massepotential des Empfängers gesetzt ist. Hierdurch wird die Photodiode 11 auch gegen von oben einfallende elektromagnetische Störungen abgeschirmt. Die genannte Abschirmschicht kann beispielsweise aus dotiertem Polysilizium oder aus ITO (indium tin oxide) bestehen. Vorzugsweise ist die Abschirmschicht mittels einer Isolierschicht, beispielsweise aus Siliziumdioxid, von der aktiven Schicht der Photodiode 11 getrennt.

Fig. 5 zeigt, dass die erläuterte wannenförmige Vertiefung 17 des Masse-Leiterstreifens 15 nicht zwingend erforderlich ist. Hier sind die Photodiode 11 und der Steuerschaltkreis 13 stattdessen auf gleicher Höhe auf dem Masse-Leiterstreifen 15 angeordnet. Die Photodiode 11 und der Steuerschaltkreis 13 sind wiederum mittels des Signal-Bonddrahts 21 verbunden. Dieser wird von zwei Abschirm-Bonddrähten 27 überquert.

### Bezugszeichenliste

- 11: Photodiode
- 13: Steuerschaltkreis
- 15: Masse-Leiterstreifen
- 17: Vertiefung
- 19: Masse-Anschlussbeinchen
- 21: Signal-Bonddraht
- 23: Bonddraht
- 25: Anschlussbeinchen
- 27: Abschirm-Bonddraht
- 29: Gehäuse

## Patentansprüche

1. Optoelektronischer Empfänger, insbesondere Fernsteuer-Empfangsmodul,
mit einem lichtempfindlichen Halbleiterbauelement (11) und einem Steuerschaltkreis (13),
wobei das lichtempfindliche Halbleiterbauelement mit dem Steuerschaltkreis zur Übertragung von Empfangssignalen mittels einer Signalleitung (21) verbunden ist,
**dadurch gekennzeichnet,**
**dass** der optoelektronische Empfänger wenigstens einen Abschirm-Bonddraht (27) aufweist, der quer zu der Signalleitung (21) verläuft, die Signalleitung übergreift und an beiden Enden mit einem Konstantpotentialanschluss (15) verbunden ist.

2. Optoelektronischer Empfänger nach Anspruch 1,
**dadurch gekennzeichnet,**
**dass** der Abschirm-Bonddraht (27) mit dem Konstantpotentialanschluss (15) eine geschlossene Schleife bildet, die die Signalleitung (21) umschließt.

3. Optoelektronischer Empfänger nach einem der vorhergehenden Ansprüche,
**dadurch gekennzeichnet,**
**dass** der Abschirm-Bonddraht (27) an beiden Enden mit einem Masse-Leiterstreifen (15) verbunden ist.

4. Optoelektronischer Empfänger nach Anspruch 3,
**dadurch gekennzeichnet,**
**dass** das lichtempfindliche Halbleiterbauelement (11) und der Steuerschaltkreis (13) auf dem Masse-Leiterstreifen (15) angeordnet sind.

5. Optoelektronischer Empfänger nach einem der Ansprüche 3 oder 4,
**dadurch gekennzeichnet,**
**dass** an dem Masse-Leiterstreifen (15) eine wannenförmige Vertiefung (17) ausgebildet ist, und
**dass** das lichtempfindliche Halbleiterbauelement (11) in der Vertiefung (17) angeordnet ist.

6. Optoelektronischer Empfänger nach einem der vorhergehenden Ansprüche,
**dadurch gekennzeichnet,**
**dass** der optoelektronische Empfänger mehrere Abschirm-Bonddrähte (27) aufweist.

7. Optoelektronischer Empfänger nach einem der vorhergehenden Ansprüche,
**dadurch gekennzeichnet,**
**dass** die Signalleitung (21) durch einen Bonddraht gebildet ist.

8. Optoelektronischer Empfänger nach einem der vorhergehenden Ansprüche,
**dadurch gekennzeichnet,**
**dass** das lichtempfindliche Halbleiterbauelement (11) an der Lichteintrittsseite mit einer Abschirmschicht aus einem leitfähigen und lichtdurchlässigen Material versehen ist.

9. Optoelektronischer Empfänger nach einem der vorhergehenden Ansprüche,
**dadurch gekennzeichnet,**
**dass** das lichtempfindliche Halbleiterbauelement (11), der Steuerschaltkreis (13), die Signalleitung (21) und der Abschirm-Bonddraht (27) in einem gemeinsamen transparenten Gehäuse (29) vergossen sind.

10. Optoelektronischer Empfänger nach einem der vorhergehenden Ansprüche,
**dadurch gekennzeichnet,**
**dass** das lichtempfindliche Halbleiterbauelement (11) im infraroten Wellenlängenbereich empfindlich ist,
und/oder
**dass** das lichtempfindliche Halbleiterbauelement (11) durch eine Photodiode oder einen Phototransistor gebildet ist.
